# EUROPEAN PATENT APPLICATION

(11) **EP 4 650 483 A1**
(43) Date of publication of application: **19.11.2025**
(21) Application number: 25166299.5
(22) Date of filing: 26.03.2025
(51) Int. Cl.: C23C 16/04, C23C 16/34, C23C 16/455

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 26.03.2024 JP 2024050307
(71) Applicant: Kokusai Electric Corporation, Tokyo 101-0045 (JP)
(72) Inventor: NOHARA, Shingo, Toyama-shi, Toyama, 9392393 (JP); ISHIBASHI, Kiyohisa, Toyama-shi, Toyama, 9392393 (JP); YAMANE, Yoma, Toyama-shi, Toyama, 9392393 (JP)
(74) Representative: Bardehle Pagenberg Partnerschaft mbB Patentanwälte Rechtsanwälte

(57) **Abstract**

There is provided a technique that includes forming a film on a substrate (200) by performing a cycle a predetermined number of times, the cycle including: (a) supplying an inhibitor to the substrate (200); (b) supplying a first precursor from a first reservoir (240a) to the substrate (200); (c) supplying a second precursor from a second reservoir (240b) to the substrate (200); and (d) supplying a reactant to the substrate (200).

## Description

### CROSS-REFERENCE TO RELATED APPLICATION

This application is based upon and claims the benefit of priority from Japanese Patent Application No. 2024-050307, filed on March 26, 2024, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In the related art, as a process of processing a substrate (a process of manufacturing a semiconductor device), a process of forming a film on a substrate may be often carried out.

### SUMMARY

Some embodiments of the present disclosure provide a technique capable of improving a step coverage of a film formed on a substrate.

According to embodiments of the present disclosure, there is provided a technique that includes forming a film on a substrate by performing a cycle a predetermined number of times, the cycle including: (a) supplying an inhibitor to the substrate; (b) supplying a first precursor from a first reservoir to the substrate; (c) supplying a second precursor from a second reservoir to the substrate; and (d) supplying a reactant to the substrate.

### BRIEF DESCRIPTION OF DRAWINGS

The accompanying drawings, which are incorporated in and constitute a part of the specification, illustrate embodiments of the present disclosure.
FIG. 1 is a schematic configuration diagram of a vertical process furnace of a substrate processing apparatus suitably used in embodiments of the present disclosure, in which a portion of the process furnace is shown in a vertical cross-sectional view.
FIG. 2 is a schematic configuration diagram of the vertical process furnace of the substrate processing apparatus suitably used in the embodiments of the present disclosure, in which a portion of the process furnace is shown in a cross-sectional view taken along line A-A in FIG. 1.
FIG. 3 is a schematic configuration diagram of a controller of the substrate processing apparatus suitably used in the embodiments of the present disclosure, in which a control system of the controller is shown in a block diagram.
FIG. 4 is a diagram showing a processing sequence according to the embodiments of the present disclosure.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

### <Embodiments of the Present Disclosure>

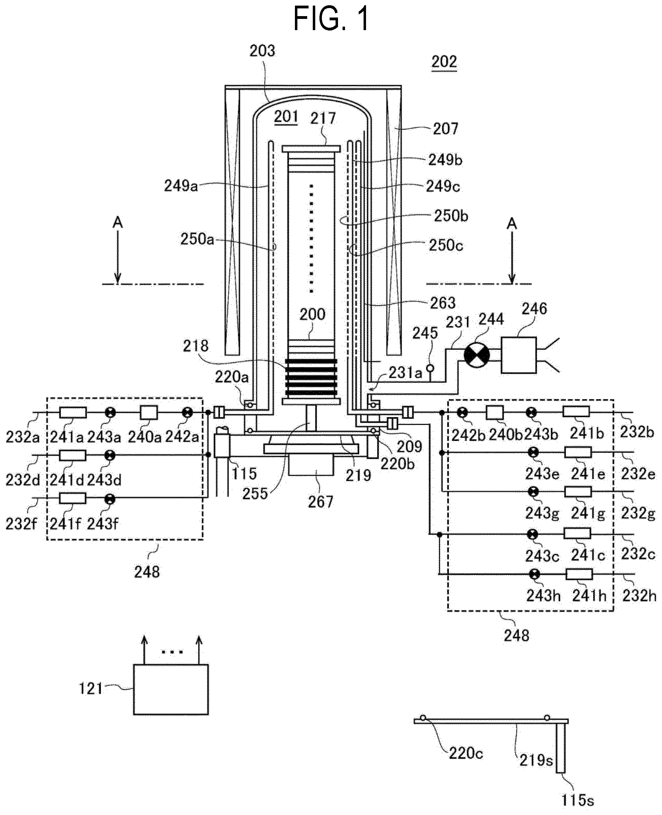

Embodiments of the present disclosure are now described mainly with reference to FIGS. 1 to 4. The drawings used in the following description are schematic, and dimensional relationships, proportions, and the like of respective elements shown in the drawings do not always match those in reality. Further, the dimensional relationships, proportions, and the like of respective elements do not always match among multiple drawings.

### (1) Configuration of Substrate Processing Apparatus

As shown in FIG. 1, a process furnace 202 includes a heater 207 as a temperature regulator (a heating part). The heater 207 is formed in a cylindrical shape and is supported by a support plate so as to be vertically installed. The heater 207 also functions as an activator (an exciter) configured to thermally activate (excite) a gas.

A reaction tube 203 is disposed inside the heater 207 to be concentric with the heater 207. The reaction tube 203 is made of, for example, a heat resistant material such as quartz or silicon carbide (SiC), and is formed in a cylindrical shape with its upper end closed and its lower end opened. Below the reaction tube 203, a manifold 209 (hereinafter referred to as a MF 209) is disposed to be concentric with the reaction tube 203. An upper end of the MF 209 engages with the lower end of the reaction tube 203 so as to support the reaction tube 203. An O-ring 220a serving as a seal is provided between the MF 209 and the reaction tube 203. Similar to the heater 207, the reaction tube 203 is vertically installed. A process container (reaction container) mainly includes the reaction tube 203 and the MF 209. A process chamber 201 is formed in a hollow cylindrical portion of the process container. The process chamber 201 is configured to be capable of accommodating a plurality of wafers 200 as substrates. Processing on the wafers 200 is performed in the process chamber 201.

Nozzles 249a to 249c as first to third suppliers are installed in the process chamber 201 so as to penetrate through a sidewall of the MF 209. The nozzles 249a to 249c are also referred to as first to third nozzles, respectively. The nozzles 249a to 249c are made of, for example, a heat resistant material such as quartz or SiC. Gas supply pipes 232a to 232c are connected to the nozzles 249a to 249c, respectively. The nozzles 249a to 249c are different nozzles from each other.

On the gas supply pipes 232a and 232b, mass flow controllers (MFCs) 241a and 241b, which are flow rate controllers (flow rate control parts), valves 243a and 243b, which are opening/closing valves, first and second reservoirs 240a and 240b, which are configured to be capable of temporarily storing a gas, and valves 242a and 242b are respectively installed sequentially from an upstream of a gas flow. Gas supply pipes 232d and 232f are connected to the gas supply pipe 232a at a downstream of the valve 242a. Gas supply pipes 232e and 232g are connected to the gas supply pipe 232b at a downstream of the valve 242b. On the gas supply pipes 232d to 232g, MFCs 241d to 241g and valves 243d to 243g are respectively installed sequentially from an upstream of a gas flow.

The first reservoir 240a and the second reservoir 240b are each configured as, for example, a gas tank or a spiral pipe with a larger gas capacity than a normal pipe. By opening/closing the valves 243a and 243b on an upstream of the first reservoir 240a and the second reservoir 240b and the valves 242a and 242b on a downstream of the first reservoir 240a and the second reservoir 240b, respectively, filling of the first reservoir 240a and the second reservoir 240b with a gas supplied from the gas supply pipes 232a and 232b or supply of the gas filled in the first reservoir 240a and the second reservoir 240b into the process chamber 201 may be performed respectively. It is preferable that a conductance between the first reservoir 240a and the process chamber 201 is configured to be, for example, 1.5 × 10⁻³ m³/s or more. In addition, considering a ratio between a volume of the process chamber 201 and a volume of the first reservoir 240a, when the volume of the process chamber 201 is 100 L (liters), the volume of the first reservoir 240a is preferably, for example, 100 to 300 cc, and is preferably, for example, 1/1,000 to 3/1,000 times the volume of the process chamber 201. The same applies to the second reservoir 240b.

By closing the valves 242a and 242b and opening the valves 243a and 243b, a gas whose flow rate is regulated by the MFCs 241a and 241b may be filled into the first reservoir 240a and the second reservoir 240b, respectively. When the first reservoir 240a and the second reservoir 240b are filled with a predetermined amount of gas and internal pressures of the first reservoir 240a and the second reservoir 240b reach a predetermined pressure, the valves 243a and 243b are closed and the valves 242a and 242b are opened, so that the high-pressure gas filled in the first reservoir 240a and the second reservoir 240b may be supplied into the process chamber 201 at once in a short time (flash supply) via the gas supply pipes 232a and 232b and the nozzles 249a and 249b. Note that the valves 243a and 243b may be opened during the flash supply.

On the gas supply pipe 232c, a MFC 241c and a valve 243c, which is an opening/closing valve, is provided sequentially from an upstream side a gas flow. A gas supply pipe 232h is connected to the gas supply pipe 232c on a downstream of the valve 243c. On the gas supply pipe 232h, a MFC 241h and a valve 243h are provided sequentially from an upstream of a gas flow.

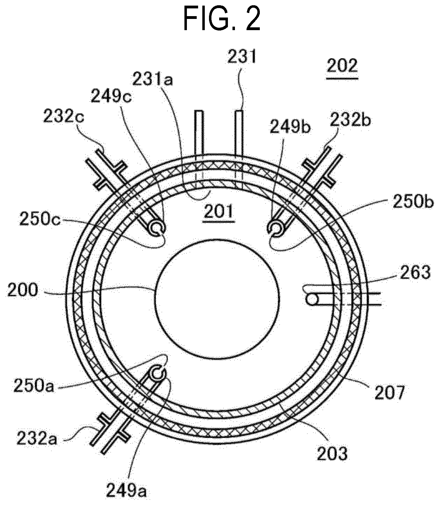

As shown in FIG. 2, each of the nozzles 249a to 249c is provided in a space, which is annular in a plane view, between an inner wall of the reaction tube 203 and the wafers 200 so as to extend upward from a lower portion of the inner wall of the reaction tube 203 to an upper portion thereof, that is, along an arrangement direction of the wafers 200. That is, each of the nozzles 249a to 249c is provided in a region horizontally surrounding a wafer arrangement region in which the wafers 200 are arranged, on a lateral side of the wafer arrangement region along the wafer arrangement region.

The nozzle 249a is disposed farther from an exhaust port 231a, which is described later, than the nozzles 249b and 249c. That is, the nozzles 249b and 249c are disposed closer to the exhaust port 231a than the nozzle 249a. Further, in a plane view, the nozzles 249b and 249c are disposed in line symmetry with a straight line that is passing through centers of the wafers 200 in a state in which the wafers 200 are loaded into the process chamber 201, i.e., a center of the reaction tube 203, and a center of the exhaust port 231a, as an axis of symmetry. Further, the nozzles 249a and 249b are disposed to face each other on a straight line with the center of the reaction tube 203 therebetween. That is, the nozzle 249b is disposed so as to face (oppose) the nozzle 249a.

Gas supply holes 250a to 250c for supplying gases are provided on side surfaces of the nozzles 249a to 249c, respectively. Each of the gas supply holes 250a to 250c is opened toward the center of the reaction tube 203, which enables the gases to be supplied toward the wafers 200. The gas supply holes 250a and 250b are opened so as to face (oppose) each other on a straight line with the centers of the wafers 200 , that is, the center of the reaction tube 203, therebetween. The gas supply holes 250a to 250c are formed in plural from the lower portion of the reaction tube 203 to the upper portion thereof.

A first precursor is supplied from the gas supply pipe 232a into the process chamber 201 via the MFC 241a, the valve 243a, the first reservoir 240a, the valve 242a, and the nozzle 249a.

A second precursor is supplied from the gas supply pipe 232b into the process chamber 201 via the MFC 241b, the valve 243b, the second reservoir 240b, the valve 242b, and the nozzle 249b.

A reactant is supplied from the gas supply pipe 232c into the process chamber 201 via the MFC 241c, the valve 243c, and the nozzle 249c.

A first inhibitor (inhibitor) is supplied from the gas supply pipe 232d into the process chamber 201 via the MFC 241d, the valve 243d, and the nozzle 249a.

A second inhibitor (inhibitor) is supplied from the gas supply pipe 232e into the process chamber 201via the MFC 241e, the valve 243e, and the nozzle 249b.

An inert gas is supplied from the gas supply pipes 232f to 232h into the process chamber 201 via the MFCs 241f to 241h, the valves 243f to 243h, the gas supply pipes 232a to 232c, and the nozzles 249a to 249c, respectively. The inert gas acts as a purge gas, a carrier gas, a dilution gas, or the like.

A first precursor supply system mainly includes the gas supply pipe 232a, the MFC 241a, the valves 243a and 242a, and the first reservoir 240a. A second precursor supply system mainly includes the gas supply pipe 232b, the MFC 241b, the valves 243b and 242b, and the second reservoir 240b. A reactant supply system mainly includes the gas supply pipe 232c, the MFC 241c, and the valve 243c. A first supply system (first inhibitor supply system/inhibitor supply system) mainly includes the gas supply pipe 232d, the MFC 241d, and the valve 243d. A second supply system (second inhibitor supply system) mainly includes the gas supply pipe 232e, the MFC 241e, and the valve 243e. An inert gas supply system mainly includes the gas supply pipes 232f to 232h, the MFCs 241f to 241h, and the valves 243f to 243h. Note that the nozzles connected to the gas supply pipes constituting the above-mentioned various supply systems may be included in the respective supply systems. For example, a gas supply system includes the first precursor supply system, the second precursor supply system, the reactant supply system, the first supply system, the second supply system, the inert gas supply system, and a controller 121 which is a control part to be described later.

Any of or the entire various gas supply systems described above may be configured as an integrated-type gas supply system 248 in which the valves 243a to 243h, 242a, and 242b, the first reservoir 240a, the second reservoir 240b, the MFCs 241a to 241h, and so on are integrated. The integrated-type gas supply system 248 is connected to each of the gas supply pipes 232a to 232h. In addition, the integrated-type gas supply system 248 is configured such that operations of supplying various types of gases into the gas supply pipes 232a to 232h, i.e., the opening/closing operations of the valves 243a to 243h, 242a, and 242b, the flow rate regulating operations by the MFCs 241a to 241h, and the like, are controlled by the controller 121 which is described later. The integrated-type gas supply system 248 is configured as an integral type or detachable-type integrated unit, and may be attached to and detached from the gas supply pipes 232a to 232h and the like on an integrated unit basis, so that the maintenance, replacement, extension, etc., of the integrated-type gas supply system 248 may be performed on an integrated unit basis.

The exhaust port 231a for exhausting the atmosphere inside the process chamber 201 is provided at a lower side of a sidewall of the reaction tube 203. As shown in FIG. 2, in a plane view, the exhaust port 23 1a is provided at a position facing (opposing) the nozzles 249a to 249c (the gas supply holes 250a to 250c) with the wafers 200 interposed therebetween. The exhaust port 231a may be provided from a lower portion of the sidewall of the reaction tube 203 to an upper portion thereof, that is, along the wafer arrangement region. An exhaust pipe 231 as an exhaust path is connected to the exhaust port 231a. A vacuum pump 246 as a vacuum exhauster is connected to the exhaust pipe 231 via a pressure sensor 245, which serves as a pressure detector (pressure detection part) that detects the pressure inside the process chamber 201, and an auto pressure controller (APC) valve 244, which serves as a pressure regulator (pressure regulation part). The APC valve 244 as an exhaust valve is configured to perform or stop a vacuum-exhaust in the process chamber 201 by opening/closing the valve while the vacuum pump 246 is operating. The APC valve 244 is also configured to be capable of regulating the pressure inside the process chamber 201 by adjusting a valve opening degree based on pressure information detected by the pressure sensor 245 while the vacuum pump 246 is operating. An exhaust system mainly includes the exhaust pipe 231, the APC valve 244, and the pressure sensor 245. The vacuum pump 246 may also be considered as included in the exhaust system.

A seal cap 219 (hereinafter referred to as a SC 219), which serves as a furnace opening lid capable of hermetically sealing an opening at a lower end of the MF 209, is installed under the manifold 209. The SC 219 is made of, for example, a metal material such as SUS and is formed in a disc shape. An O-ring 220b, which is a seal making contact with the lower end of the MF 209, is provided on an upper surface of the SC 219. A rotator 267 configured to rotate a boat 217, which is described later, is installed below the SC 219. A rotating shaft 255 of the rotator 267 is made of, for example, a metal material such as SUS and passes through the SC 219 to be connected to the boat 217. The rotator 267 is configured to rotate the wafers 200 by rotating the boat 217. The SC 219 is configured to be vertically moved up and down by a boat elevator 115 (hereinafter referred to as a BE 115), which is a lift installed outside the reaction tube 203. The BE 115 is configured as a transfer apparatus (transfer mechanism) which loads/unloads (transfers) the wafers 200 into/out of the process chamber 201 by moving the SC 219 up and down.

A shutter 219s, which serves as a furnace opening lid capable of hermetically sealing the opening at the lower end of the MF 209 in a state where the SC 219 is lowered and the boat 217 is unloaded from the process chamber 201, is installed below the MF 209. The shutter 219s is made of, for example, a metal material such as SUS and is formed in a disc shape. An O-ring 220c, which is a seal making contact with the lower end of the MF 209, is provided on an upper surface of the shutter 219s. The opening/closing operation (such as elevating operation, rotating operation, or the like) of the shutter 219s is controlled by a shutter opening/closing mechanism 115s.

The boat 217 serving as a substrate support is configured to support a plurality of wafers 200, for example, 25 to 200 wafers, in such a state that the wafers 200 are arranged in a horizontal posture and in multiple stages along a vertical direction with the centers of the wafers 200 aligned with one another. That is, the boat 217 is configured to arrange the wafers 200 to be spaced apart from each other. The boat 217 is made of, for example, a heat resistant material such as quartz or SiC. At a lower portion of the boat 217, heat insulating plates 218 made of, for example, a heat resistant material such as quartz or SiC are supported in multiple stages.

A temperature sensor 263 serving as a temperature detector is installed in the reaction tube 203. Based on temperature information detected by the temperature sensor 263, a state of supplying electric power to the heater 207 is regulated such that a temperature inside the process chamber 201 achieves a desired temperature distribution. The temperature sensor 263 is installed along the inner wall of the reaction tube 203.

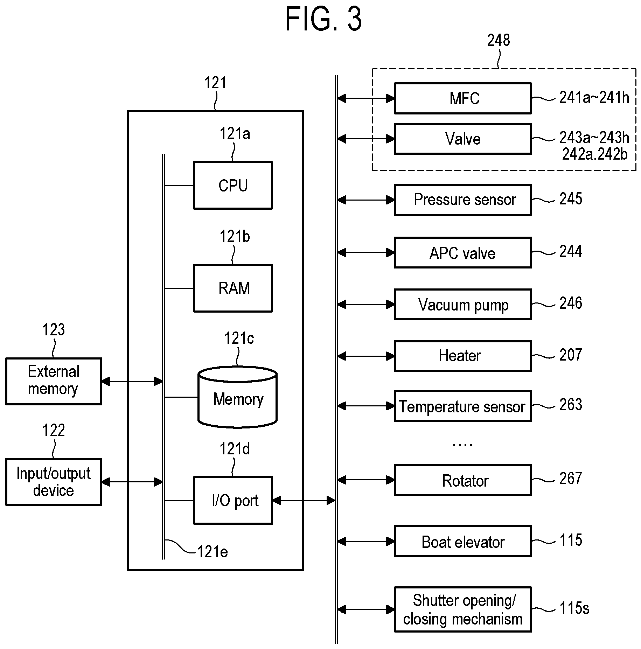

As shown in FIG. 3, the controller 121, which is a control part (control means), is configured as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus 121e. An input/output device 122 formed of, e.g., a touch panel or the like, is connected to the controller 121. Further, an external memory 123 may be connected to the controller 121. Note that the substrate processing apparatus may be configured to include a single controller or may be configured to include a plurality of controllers. That is, control for performing a processing sequence to be described later may be performed using a single controller, or may be performed using a plurality of controllers. Further, the plurality of controllers may be configured as a control system in which the plurality of controllers are connected to each other via a wired or wireless communication network, and the entire control system may perform control for performing the processing sequence to be described later. When the term "controller" is used in the present disclosure, it may refer to a case of including a single controller, as well as a case of including a plurality of controllers or a case of a control system being configured by a plurality of controllers.

The memory 121c is configured by, for example, a flash memory, a hard disk drive (HDD), a solid state drive (SSD), or the like. The memory 121c stores, in a readable manner, a control program for controlling operations of a substrate processing apparatus, a process recipe in which procedures, conditions, etc., of substrate processing to be described later are written, and others. The process recipe is a combination that causes the controller 121 to execute each procedure of the substrate processing to be described later, in the substrate processing apparatus, to obtain predetermined results, and functions as a program. Hereinafter, the process recipe, the control program, or the like are collectively and simply referred to as a "program."
Furthermore, the process recipe may be simply referred to as a "recipe." When the term "program" is used herein, it may indicate a case of including the recipe, a case of including the control program, or a case of including both the recipe and the control program. The RAM 121b is configured as a memory area (work area) in which programs, data, or the like, read by the CPU 121a are temporarily stored.

The I/O port 121d is connected to the MFCs 241a to 241h, the valves 243a to 243h, 242a, and 242b, the pressure sensor 245, the APC valve 244, the vacuum pump 246, the temperature sensor 263, the heater 207, the rotator 267, the BE 115, the shutter opening/closing mechanism 115s, and so on.

The CPU 121a is configured to read and execute the control program from the memory 121c. The CPU 121a is also configured to read the recipe from the memory 121c according to an input of an operation command and the like from the input/output device 122. The CPU 121a is configured to be capable of, according to contents of the recipe thus read, controlling the flow rate regulating operations of various kinds of materials (gases) by the MFCs 241a to 241h, the opening/closing operations of the valves 243a to 243h, 242a, and 242b, the opening/closing operation of the APC valve 244, the pressure regulating operation performed by the APC valve 244 based on the pressure sensor 245, the start and shutdown of the vacuum pump 246, the temperature regulating operation performed by the heater 207 based on the temperature sensor 263, the operation of rotating the boat 217 with the rotator 267 and adjusting the rotation speed of the boat 217, the operation of moving the boat 217 up and down by the BE 115, the opening/closing operation of the shutter 219s by the shutter opening/closing mechanism 115s, and so on.

The controller 121 may be configured by installing, on the computer, the aforementioned program recorded and stored in the external memory 123. Examples of the external memory 123 may include a magnetic disk such as a HDD, an optical disc such as a CD, a semiconductor memory such as a USB memory or a SSD, and the like. The memory 121c or the external memory 123 is configured as a non-transitory computer-readable recording medium. Hereinafter, the memory 121c and the external memory 123 may be collectively and simply referred to as a "recording medium." When the term "recording medium" is used herein, it may indicate a case of including the memory 121c, a case of including the external memory 123, or a case of including both the memory 121c and the external memory 123. Furthermore, the program (program product) may be provided to the computer by using communication means such as the Internet or a dedicated line, instead of using the external memory 123.

### (2) Substrate Processing Process

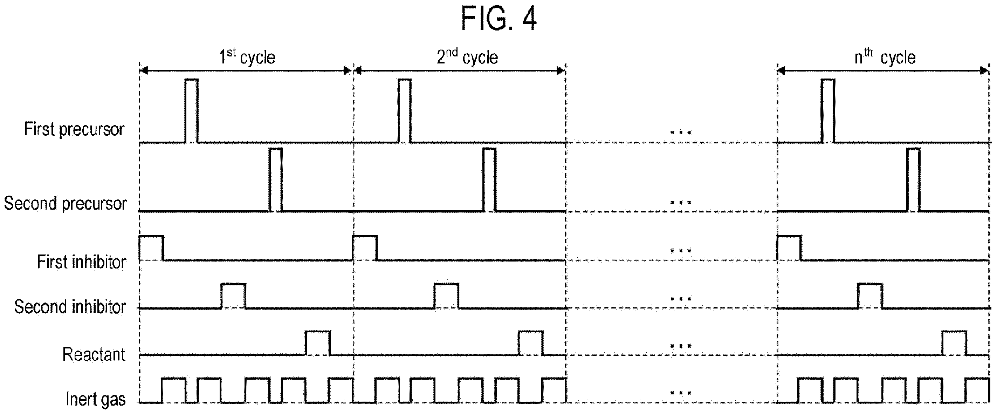

As a process of manufacturing a semiconductor device by using the above-described substrate processing apparatus, a method of processing a substrate, that is, an example of a processing sequence for forming a film on the wafer 200, serving as a substrate whose surface includes a three-dimensional structure of a recess such as a trench, a groove, and a hole, is described mainly with reference to FIG. 4. In the following description, the operations of the respective components constituting the substrate processing apparatus are controlled by the controller 121.

A processing sequence in the present embodiments includes:
a step of forming a film on the wafer 200 by performing a cycle a predetermined number of times (n times, where n is an integer of 1 or 2 or more), the cycle including:
(a) step A of supplying an inhibitor to the wafer 200;
(b) step B of supplying a first precursor from the first reservoir 240a to the wafer 200;
(c) step C of supplying a second precursor from the second reservoir 240b to the wafer 200; and
(d) step D of supplying a reactant to the wafer 200.

Step A may include at least one selected from the group of step a1 of supplying a first inhibitor to the wafer 200 before step B, and step a2 of supplying a second inhibitor to the wafer 200 before step C. FIG. 4 shows, as an example, a case where a cycle including performing step a1, step B, step a2, step C, and step D sequentially is performed a predetermined number of times (n times).

In other words, the processing sequence shown in FIG. 4 shows an example with a step of forming a film on the wafer 200 by performing a cycle a predetermined number of times (n times, where n is an integer of 1 or 2 or more), the cycle including:
step a1 of supplying the first inhibitor to the wafer 200;
step B of supplying the first precursor from the first reservoir 240a to the wafer 200;
step a2 of supplying the second inhibitor to the wafer 200;
step C of supplying the second precursor from the second reservoir 240b to the wafer 200; and
step D of supplying the reactant to the wafer 200.

In the present disclosure, for the sake of convenience, the above-described processing sequence may be denoted as follows. The same denotation may be used in modifications and other embodiments to be described later.

### (First inhibitor → Purge → First precursor → Purge → Second inhibitor → Purge → Second precursor → Purge → Reactant → Purge) × n

When the term "wafer" is used in the present disclosure, it may refer to "a wafer itself" or "a stacked body including a wafer and a predetermined layer or film formed on a surface of the wafer." When the term "a surface of a wafer" is used in the present disclosure, it may refer to "a surface of a wafer itself" or "a surface of a predetermined layer formed on a wafer." When the expression "a predetermined layer is formed on a wafer" is used in the present disclosure, it may mean that "a predetermined layer is formed directly on a surface of a wafer itself" or that "a predetermined layer is formed on a layer and the like formed on a wafer." When the term "substrate" is used in the present disclosure, it may be synonymous with the term "wafer."

The term "agent" used in the present disclosure includes at least one selected from the group of a gaseous substance and a liquid substance. The liquid substance includes a mist-like substance. That is, each of the inhibitors (the first inhibitor and the second inhibitor) may include a gaseous substance, a liquid substance such as a mist-like substance, or both of them.

The term "layer" used in the present disclosure includes at least one selected from the group of a continuous layer and a discontinuous layer. For example, first to third layers, which are described later, may include a continuous layer, a discontinuous layer, or both of them.

In the present disclosure, when it is mentioned that the first inhibitor, the second inhibitor, the first precursor, the second precursor, and the reactant adsorb on or react with the surface of the wafer 200, it may include a case in which they adsorb on or react with the surface of the wafer with them remain undecomposed, as well as a case in which they decompose, or a case in which intermediates produced by detachment of their ligands are adsorb on or react with the surface of the wafer 200.

### (Wafer Charging and Boat Loading)

After the boat 217 is charged with a plurality of wafers 200 (wafer charging), the shutter 219s is moved by the shutter opening/closing mechanism 115s and the opening at the lower end of the MF 209 is opened (shutter open). Thereafter, as shown in FIG. 1, the boat 217 supporting the plurality of wafers 200 is lifted up by the BE 115 to be loaded into the process chamber 201 (boat loading). In this state, the SC 219 seals the lower end of the MF 209 through the O-ring 220b.

### (Pressure Regulation and Temperature Regulation)

After the boat loading is completed, an interior of the process chamber 201, that is, a space where the wafers 200 are placed, is vacuum-exhausted (decompression-exhausted) by the vacuum pump 246 to reach a desired pressure (degree of vacuum). At this time, the pressure inside the process chamber 201 is measured by the pressure sensor 245, and the APC valve 244 is feedback-controlled based on the measured pressure information (pressure regulation). Further, the wafers 200 in the process chamber 201 are heated by the heater 207 so as to achieve a desired processing temperature. At this time, electric power supplied to the heater 207 is feedback-controlled based on the temperature information detected by the temperature sensor 263 so that the interior of the process chamber 201 achieves a desired temperature distribution (temperature regulation). Further, the rotation of the wafers 200 by the rotator 267 is started. The exhaust of the interior of the process chamber 201 and the heating and rotation of the wafers 200 are continuously performed at least until the processing on the wafers 200 is completed.

### (Film-Forming Process)

Thereafter, the following steps a1, B, a2, C, and D are performed sequentially.

### [Step a1]

In this step, the first inhibitor is supplied to the wafer 200 in the process chamber 201.

Specifically, the valve 243d is opened to allow the first inhibitor to flow into the gas supply pipe 232d. A flow rate of the first inhibitor is regulated by the MFC 241d, and the first inhibitor is supplied into the process chamber 201 via the nozzle 249a and is exhausted through the exhaust port 231a. At this time, the first inhibitor is supplied to the wafer 200 (first inhibitor supply). At this time, the valves 243f to 243h may be opened to allow an inert gas to be supplied into the process chamber 201 via the nozzles 249a to 249c, respectively.

Processing conditions for supplying the first inhibitor in step a1 are exemplified as follows:
Processing temperature: 250 to 800 degrees C, specifically 600 to 700 degrees C
Processing pressure: 1 to 3,990 Pa, specifically 10 to 1,333 Pa
First inhibitor supply flow rate: 0.005 to 5 slm, specifically 0.1 to 1 slm
First inhibitor supply time: 10 to 120 seconds, specifically 20 to 60 seconds
Inert gas supply flow rate (for each gas supply pipe): 0 to 10 slm

The notation of a numerical range such as "250 to 800 degrees C" in the present disclosure means that the lower limit value and the upper limit value are included in the range. Therefore, for example, "250 to 800 degrees C" means "250 or higher and 800 or lower degrees C ". The same applies to other numerical ranges. In addition, the processing temperature in the present disclosure means a temperature of the wafer 200 or the temperature inside the process chamber 201. The processing time means time for which the processing continues. The supply flow rate means a flow rate of a gas supplied into the process chamber 201. Further, when the gas supply flow rate includes 0 slm, 0 slm means a case where no substance (gas) is supplied. These apply equally to the following description.

By supplying the first inhibitor to the wafer 200 under the above-mentioned processing conditions, the first inhibitor may be adsorbed on adsorption sites of the surface of the wafer 200. Specifically, the first inhibitor may be adsorbed on at least a portion of an upper surface and inner surface of a recess (specifically, a side surface and a bottom surface inside the recess) formed on the surface of the wafer 200. More specifically, the first inhibitor may be preferentially adsorbed on an opening side (upper side) of the recess rather than a deeper side thereof.

As the first inhibitor, a gas containing at least one selected from the group of chlorine (Cl), fluorine (F), bromine (Br), and iodine (I), which are halogen elements, may be used. As the first inhibitor, for example, a simple gas of a halogen element such as a Cl₂ gas, a F₂ gas, a Br₂ gas, or an I₂ gas, an interhalogen compound gas such as a ClF₃ gas, a BrCl gas, an ICl gas, an IF₅ gas, a BrF₃ gas, or an IBr gas, a hydrogen halide compound gas such as a HCl gas, a HF gas, a HBr gas, or a HI gas, or a combination of these gases may be used. In addition, radicals (Cl*, F*, Br*, I*, etc.) containing a halogen element generated by activating these gases by plasma excitation or the like may be used. One or more of these gases may be used as the first inhibitor.

In addition, as the first inhibitor, a gas containing an organic compound may be used. As the gas containing an organic compound, a gas containing at least one selected from the group of an ether compound, a ketone compound, an amine compound, an organic hydrazine compound, and a compound with a cyclic structure in its molecular structure may be used. As the gas containing the ether compound, a gas containing at least one selected from the group of dimethyl ether, diethyl ether, methyl ethyl ether, propyl ether, isopropyl ether, furan, tetrahydrofuran, pyran, tetrahydropyran, etc., may be used. As the gas containing the ketone compound, a gas containing at least one selected from the group of dimethyl ketone, diethyl ketone, methyl ethyl ketone, methyl propyl ketone, etc., may be used. As the gas containing the amine compound, a gas containing at least one selected from the group of a methylamine compound such as monomethylamine, dimethylamine, or trimethylamine, an ethylamine compound such as monoethylamine, diethylamine, or triethylamine, and a methylethylamine compound such as dimethylethylamine or methyldiethylamine may be used. As the gas containing the organic hydrazine compound, a gas containing at least one selected from the group of methylhydrazine-based gases such as monomethylhydrazine, dimethylhydrazine, and trimethylhydrazine may be used. As the gas containing the compound with the cyclic structure, a gas with a cyclic structure, containing at least one selected from the group of a cycloalkyl group such as methoxycyclopentane, anisole, or trimethylene oxide, a benzene ring structure, and carbon, in its molecular structure may be used. One or more of these gases may be used as the first inhibitor.

In addition, as the first inhibitor, an alkyl group-containing gas containing an alkyl group may be used. As the first inhibitor, a CH₄ gas, a C₂H₆ gas, a C₃H₈ gas, etc., may be used.

As the inert gas, a N₂ gas or a rare gas such as an Ar gas, a He gas, a Ne gas, or a Xe gas may be used. One or more of these gases may be used as the inert gas. This also applies to each step to be described later.

After the first inhibitor is adsorbed on the surface of the wafer 200, the valve 243d is closed to stop the supply of the first inhibitor into the process chamber 201. Then, the process chamber 201 is vacuum-exhausted to remove gaseous substances and the like remaining in the process chamber 201 from the process chamber 201. At this time, the valves 243f to 243h are opened to allow an inert gas to be supplied into the process chamber 201 via the nozzles 249a to 249c. The inert gas supplied from the nozzles 249a to 249c acts as a purge gas, whereby a space wherein the wafer 200 is placed, i.e., the interior of the process chamber 201, is purged (purge).

In addition, during the execution of step a1, with the valve 242a closed, the valve 243a is opened to allow the first precursor to flow into the gas supply pipe 232a. A flow rate of the first precursor is regulated by the MFC 241a, and the first precursor is supplied into the first reservoir 240a. Thus, the first reservoir 240a is filled with the first precursor (first tank charging). When a predetermined amount of first precursor is filled (charged) in the first reservoir 240a, the valve 243a is closed, and the state in which the first reservoir 240a is filled with the first precursor is maintained. The first tank charging may be performed before the execution of step a1.

### [Step B]

In this step, the first precursor is supplied to the wafer 200 in the process chamber 201.

Specifically, the valve 242a is opened to allow the high-pressure first precursor filled in the first reservoir 240a to flow into the process chamber 201 at once. This causes the first precursor to be supplied to the wafer 200 at once (flash supply of the first precursor). In the flash supply of the first precursor, the first precursor ejected from the nozzle 249a into the process chamber 201 is accelerated to, for example, the sonic speed (340m/sec) due to a pressure difference between the first reservoir 240a and the process chamber 201, and a speed of the first precursor on the wafer 200 also reaches about several tens of m/sec. The same also applies to flash supply of the second precursor to be described later. At this time, the valve 243a is left open. At this time, the valves 243f to 243h may be opened to allow an inert gas to be supplied into the process chamber 201 via the nozzles 249a to 249c, respectively.

Processing conditions for supplying the first precursor in step B are exemplified as follows:
Processing temperature: 250 to 800 degrees C, specifically 600 to 700 degrees C
Processing pressure: 1 to 2,666 Pa, specifically 1 to 1,333 Pa
First precursor supply flow rate: 0.001 to 5 slm, specifically 0.1 to 5 slm
First precursor supply time: 0.1 to 20 seconds, specifically 0.5 to 5 seconds
Inert gas supply flow rate (for each gas supply pipe): 0 to 10 slm

By supplying the first precursor to the wafer 200 under the above-mentioned processing conditions, the first precursor may be adsorbed on portions of the surface of the wafer 200 where the first inhibitor is not adsorbed, i.e., the adsorption sites remaining on the surface of the wafer 200, thereby forming a first layer.

Herein, the first inhibitor is a substance that inhibits adsorption of the first precursor on the wafer 200. Specifically, a functional group (e.g., a halogen group) contained in the first inhibitor and formed (exposed) on the upper surface and inner surface of the recess inhibits the adsorption of the first precursor on the wafer 200 (the upper surface and inner surface of the recess). As described above, since the first inhibitor preferentially adsorbs on the opening side of the recess, the adsorption of the first precursor is more suppressed on the opening side than on the deeper side of the recess. This allows the first precursor to be preferentially adsorbed on the deeper side of the recess to form the first layer.

In addition, in the embodiments, the first precursor is flash-supplied, so that the first precursor may be supplied to the wafer 200 in a large flow rate within a short time from the start of supply of the first precursor. This makes it possible to increase an amount of the first precursor that reaches the deeper side of the recess within a short time from the start of supply of the first precursor. Therefore, the first precursor may be more preferentially adsorbed on the deeper side of the recess, thereby forming the first layer.

As the first precursor, for example, a silane-based gas containing silicon (Si) as the main element constituting a film formed on the wafer 200 may be used. As the silane-based gas, for example, a gas containing Si and halogen, that is, a halosilane-based gas, may be used.
Halogen includes Cl, F, Br, I, etc. As the halosilane-based gas, for example, a chlorosilane-based gas containing Si and Cl may be used.

As the first precursor, for example, a chlorosilane-based gas such as a SiH₃Cl gas, a SiH₂Cl₂ gas, a SiHCl₃ gas, a SiCl₄ gas, a Si₂Cl₆ gas, a Si₃Cl₈ gas, a Si₂H₅Cl gas, a Si₂H₄Cl₂ gas, a Si₂H₃Cl₃ gas, a Si₂H₂Cl₄ gas, a Si₃H₅Cl gas, a Si₃H₄Cl₂ gas, etc. may be used. One or more of these gases may be used as the first precursor.

As the first precursor, in addition to the chlorosilane-based gas, for example, a fluorosilane-based gas such as a SiF₄ gas or a SiH₂F₂ gas, a bromosilane-based gas such as a SiBr₄ gas or a SiH₂Br₂ gas, and an iodosilane-based gas such as a SiI₄ gas or a SiH₂I₂ gas may be used. One or more of these gases may be used as the first precursor.

As the first precursor, in addition to these gases, for example, a gas containing Si and an amino group, that is, an aminosilane-based gas, may be used. The amino group is a monovalent functional group obtained by removing hydrogen (H) from ammonia, primary amine, or secondary amine, and may be expressed as -NH₂, -NHR, or -NR₂. R represents an alkyl group, and two Rs in -NR₂ may be the same or different.

As the first precursor, for example, an aminosilane-based gas (organic aminosilane-based gases) such as a (Si[N(CH₃)₂]₄) gas, a (Si[N(CH₃)₂]₃H) gas, a (Si[N(C₂H₅)₂]₂H₂) gas, a (SiH₂[NH(C₄H₉)]₂) gas, or a (SiH₃[N(C₃H₇)₂]) gas may be used. One or more of these gases may be used as the first precursor.

After the first layer is formed on the surface of the wafer 200, the valves 243a and 242a are closed to stop the supply of the first precursor into the process chamber 201. Then, the same process as (purge) described above is performed.

### [Step a2]

In this step, the second inhibitor is supplied to the wafer 200 in the process chamber 201.

Specifically, the valve 243e is opened to allow the second inhibitor to flow into the gas supply pipe 232e. A flow rate of the second inhibitor is regulated by the MFC 241e, and the second inhibitor is supplied into the process chamber 201 via the nozzle 249b and is exhausted through the exhaust port 231a. At this time, the second inhibitor is supplied to the wafer 200 (second inhibitor supply). At this time, the valves 243f to 243h may be opened to allow an inert gas to be supplied into the process chamber 201 via the nozzles 249a to 249c, respectively.

Processing conditions for supplying the second inhibitor in step a2 are exemplified as follows:
Processing temperature: 250 to 800 degrees C, specifically 600 to 700 degrees C
Processing pressure: 1 to 3,990 Pa, specifically 10 to 1,333 Pa
Second inhibitor supply flow rate: 0.005 to 5 slm, specifically 0.1 to 1 slm
Second inhibitor supply time: 10 to 120 seconds, specifically 20 to 60 seconds
Inert gas supply flow rate (for each gas supply pipe): 0 to 10 slm

By supplying the second inhibitor to the wafer 200 under the above-mentioned processing conditions, the second inhibitor may be adsorbed on portions on the surface of the wafer 200 where the first inhibitor is not adsorbed. Specifically, the second inhibitor may be adsorbed on the portions where the first inhibitor is not adsorbed, among at least portions of the upper surface and inner surface of the recess (specifically, the side surface and bottom surface inside the recess) formed on the surface of the wafer 200. More specifically, the second inhibitor may be preferentially adsorbed on the opening side of the recess rather than the deeper side thereof.

As the second inhibitor, for example, one or more of the gases exemplified as the first inhibitor may be used. As the second inhibitor, the same gas as the first inhibitor may be used, or a gas different from the first inhibitor may be used.

After the second inhibitor is adsorbed on the surface of the wafer 200, the valve 243e is closed to stop the supply of the second inhibitor into the process chamber 201. Then, the same process as (purge) described above is performed.

In addition, during the execution of step a2, with the valve 242b closed, the valve 243b is opened to allow the second precursor to flow into the gas supply pipe 232b. A flow rate of the second precursor is regulated by the MFC 241b, and the second precursor is supplied into the second reservoir 240b. Thus, the second reservoir 240b is filled with the second precursor (second tank charging). When a predetermined amount of second precursor is filled in the second reservoir 240b, the valve 243b is closed, and the state in which the second reservoir 240b is filled with the second precursor is maintained. The second tank charging may be performed before the execution of step a2.

### [Step C]

In this step, the second precursor is supplied to the wafer 200 in the process chamber 201.

Specifically, the valve 242b is opened to allow the high-pressure second precursor filled in the second reservoir 240b to flow into the process chamber 201 at once. This causes the second precursor to be supplied to the wafer 200 at once (flash supply of the second precursor). At this time, the valve 243b is left open. At this time, the valves 243f to 243h may be opened to allow an inert gas to be supplied into the process chamber 201 via the nozzles 249a to 249c, respectively.

Processing conditions for supplying the second precursor in step C are exemplified as follows:
Processing temperature: 250 to 800 degrees C, specifically 600 to 700 degrees C
Processing pressure: 1 to 2,666 Pa, specifically 1 to 1,333 Pa
Second precursor supply flow rate: 0.001 to 5 slm, specifically 0.1 to 5 slm
Second precursor supply time: 0.1 to 20 seconds, specifically 0.5 to 5 seconds
Inert gas supply flow rate (for each gas supply pipe): 0 to 10 slm

By supplying the second precursor to the wafer 200 under the above-mentioned processing conditions, the second precursor may be adsorbed on portions of the surface of the wafer 200 where at least one selected from the group of the first inhibitor and the second inhibitor is not adsorbed (in other words, portions where neither the first inhibitor nor the second inhibitor is adsorbed), thereby forming a second layer.

Herein, the first inhibitor and the second inhibitor are both substances that inhibit adsorption of the second precursor on the wafer 200. Specifically, a functional group (e.g., a halogen group) contained in the first inhibitor or the second inhibitor and formed (exposed) on the upper surface and inner surface of the recess inhibits the adsorption of the second precursor on the wafer 200 (the upper surface and inner surface of the recess). As described above, since both the first inhibitor and the second inhibitor preferentially adsorb on the opening side of the recess, the adsorption of the second precursor is more suppressed on the opening side than on the deeper side of the recess. This allows the second precursor to be preferentially adsorbed on the deeper side of the recess to form the second layer.

In addition, in the embodiments, the second precursor is flash-supplied, so that the second precursor may be supplied to the wafer 200 in a large flow rate within a short time from the start of supply of the second precursor. This makes it possible to increase an amount of the second precursor that reaches the deeper side of the recess within a short time from the start of supply of the second precursor. Therefore, the second precursor may be more preferentially adsorbed on the deeper side of the recess, thereby forming the second layer.

As the second precursor, for example, one or more of the gases exemplified as the first precursor may be used. As the second precursor, the same precursor gas (same material) as the first precursor may be used, but it is preferable to use a precursor gas (different material) different from the first precursor.

After the second layer is formed on the surface of the wafer 200, the valves 243b and 242b are closed to stop the supply of the second precursor into the process chamber 201. Then, the same process as (purge) described above is performed.

### [Step D]

After step C is completed, the reactant is supplied to the wafer 200 in the process chamber 201.

Specifically, the valve 243c is opened to allow the reactant to flow into the gas supply pipe 232c. A flow rate of the reactant is regulated by the MFC 241c, and the reactant is supplied into the process chamber 201 via the nozzle 249c and is exhausted through the exhaust port 231a. At this time, the reactant is supplied to the wafer 200 (reactant supply). At this time, the valves 243f to 243h may be opened to allow an inert gas to be supplied into the process chamber 201 via the nozzles 249a to 249c, respectively.

Processing conditions for supplying the reactant in step D are exemplified as follows:
Processing temperature: 400 to 800 degrees C, specifically 650 to 700 degrees C
Processing pressure: 10 to 10,000 Pa, specifically 20 to 5,000 Pa
Reactant supply flow rate: 0.001 to 20 slm, specifically 1 to 10 slm
Reactant supply time: 1 to 120 seconds, specifically 1 to 60 seconds
Inert gas supply flow rate (for each gas supply pipe): 0 to 10 slm

By supplying the reactant to the wafer 200 under the above-mentioned processing conditions, at least a portion among the first layer and the second layer formed on the wafer 200 reacts with the reactant and is modified. As a result, a third layer, which is a modified layer of at least one selected from the group of the first layer and the second layer, is formed on the wafer 200, specifically on the inner surface of the recess.

As the reactant, for example, a nitrogen (N)- and hydrogen (H)-containing gas, which is a nitriding gas, may be used. The N- and H-containing gas is both a N-containing gas and a H-containing gas. It is preferable that the N- and H-containing gas contains a N-H bond.

As the reactant, for example, a hydrogen nitride-based gas such as an NH₃ gas, a N₂H₂ gas, a N₂H₄ gas, or a N₃H₈ gas may be used.

As the reactant, in addition to these gases, for example, a N-, carbon (C)-, and H-containing gas may also be used. As the N-, C-, and H-containing gas, for example, an amine-based gas or an organic hydrazine-based gas may be used. The N-, C-, and H-containing gas may be a N-containing gas, a C-containing gas, a H-containing gas, and a N- and C-containing gas.

As the reactant, for example, an ethylamine-based gas such as a C₂H₅NH₂ gas, a (C₂H₅)₂NH gas, or a (C₂H₅)₃N gas, a methylamine-based gas such as a CH₃NH₂ gas, a (CH₃)₂NH gas, or a (CH₃)₃N gas, or an organic hydrazine-based gas such as a (CH₃)HN₂H₂ gas, a (CH₃)₂N₂H₂ gas, or a (CH₃)₂N₂(CH₃)H gas, etc. may be used.

One or more of these gases may be used as the reactant.

After the third layer is formed on the surface of the wafer 200, the valve 243c is closed to stop the supply of the reactant into the process chamber 201. Then, the same process as (purge) described above is performed.

### [Performing Predetermined Number of Times]

By performing a cycle n times (n is an integer of 1 or 2 or more), the cycle including non-simultaneously, that is, without synchronization, performing the above-described steps a1, B, a2, C, and D sequentially, a film may be formed on the surface of the wafer 200 (the inner surface of the recess). Moreover, by setting the number of cycles n as the number of times for filling the inside of the recess with the film, the inside of the recess is filled with the film. For example, when the above-mentioned Si-containing gas is used as the first precursor or the second precursor and the above-mentioned nitriding gas is used as the reactant, a silicon nitride film (SiN film) is formed on the surface of the wafer 200. It is preferable to repeat the above cycle a plurality of times. That is, a thickness of the third layer formed per cycle may be set to be thinner than a desired film thickness, and the above cycle may be repeated a plurality of times until a thickness of the film formed by stacking the third layers reaches the desired film thickness. Moreover, in the second and subsequent cycles, it is preferable to perform the filling of the first reservoir 240a with the first precursor in step B in parallel with the supply of the reactant in step D of a previous cycle.

### (After-Purge and Atmospheric Pressure Recovery)

After the formation of the film with the desired thickness on the wafer 200 is completed, an inert gas acting as a purge gas is supplied into the process chamber 201 from each of the nozzles 249a to 249c and is exhausted through the exhaust port 231a. Thus, the interior of the process chamber 201 is purged and any gases, reaction by-products, and the like remaining in the process chamber 201 are removed from the process chamber 201 (after-purge). Thereafter, the atmosphere inside the process chamber 201 is substituted with the inert gas (inert gas substitution) and the pressure inside the process chamber 201 is returned to the normal pressure (atmospheric pressure recovery).

### (Boat Unloading and Wafer Discharging)

After that, the SC 219 is moved down by the BE 115 to open the lower end of the MF 209. Then, the processed wafers 200 supported by the boat 217 are unloaded from the lower end of the MF 209 to an outside of the reaction tube 203 (boat unloading). After the boat unloading, the shutter 219s is moved and the opening at the lower end of the MF 209 is sealed by the shutter 219s via the O-ring 220c (shutter close). The processed wafers 200 are unloaded to the outside of the reaction tube 203 and are then discharged from the boat 217 (wafer discharging).

### (3) Effects of the Present Embodiments

According to the present embodiments, one or more effects set forth below are achieved.

The first inhibitor and the second inhibitor respectively supplied in steps a1 and a2 are preferentially adsorbed on the opening side of the recess rather than on the deeper side thereof, such that the first precursor and the second precursor respectively supplied in steps B and C are more suppressed on the opening side of the recess rather than on the deeper side thereof. Therefore, it is possible to preferentially adsorb the first precursor and the second precursor on the deeper side of the recess, so that a film may be formed at a uniform rate from the deeper side of the recess to the opening side thereof. By this, it is impossible to improve step coverage.

In steps B and C, the first precursor and the second precursor are respectively filled in the first reservoir 240a and the second reservoir 240b in advance and are then supplied into the process chamber 201. That is, the first precursor and second precursor are supplied in large flow rates at once within a short time (flash supply). This makes it possible to increase the amount of first precursor and second precursor that reaches the deeper side of the recess within a short time from the start of supply of the first precursor and the second precursor. Therefore, the first precursor and the second precursor may be more preferentially adsorbed on the deeper side of the recess, so that a film may be formed at a more uniform rate from the deeper side of the recess to the opening side thereof. This may further improve the step coverage.

By using different materials, such as materials with different numbers of Sis contained in one molecule for the first precursor and the second precursor, or an organic material for one precursor and an inorganic material for the other precursor, the precursors (first and second precursors) may be uniformly adsorbed on the wafer 200. This allows the first precursor and the second precursor to be more uniformly adsorbed from the deeper side of the recess to the opening side thereof. This may further improve the step coverage.

In addition, by supplying both the first precursor and the first inhibitor, which inhibits the adsorption of the first precursor, from the nozzle 249a, it is possible to avoid the first precursor from being adsorbed on the nozzle 249a. Similarly, by supplying both the second precursor and the second inhibitor, which inhibits the adsorption of the second precursor, from the nozzle 249b, it is possible to avoid the second precursor from being adsorbed on the nozzle 249b.

### (4) Modifications

The processing sequence in the present embodiments may be modified as in the following modifications. These modifications may be combined arbitrarily. Unless otherwise stated, processing procedures and processing conditions in each step of each modification may be the same as the processing procedures and processing conditions in each step of the above-described processing sequence.

### (Modification 1)

As shown in the processing sequence below, step a2 may not be performed, and steps a1, B, C, and D may be performed sequentially.

### (First inhibitor → Purge → First precursor → Purge → Second precursor → Purge → Reactant → Purge) × n

This modification may also obtain the same effects as in the above-described embodiments. In this modification, it is possible to shorten the cycle time, thus further improving a throughput.

### (Modification 2)

As shown in the processing sequence below, step a1 may not be performed, and steps B, a2, C, and D may be performed sequentially.

### (First precursor → Purge → Second inhibitor → Purge → Second precursor → Purge → Reactant → Purge) × n

This modification may also obtain the same effects as in the above-described embodiments. In this modification, it is possible to shorten the cycle, thus further improving a throughput.

### (Modification 3)

As shown in the processing sequence below, step a2 may not be performed, and steps a1, B, and D may be performed sequentially. Also, step C may be performed simultaneously when step B is performed.

### (First inhibitor → Purge → (First precursor + Second precursor) → Purge → Reactant → Purge) × n

This modification may also obtain the same effects as in the above-described embodiments. In this modification, it is possible to shorten the cycle time, thus further improving a throughput.

### (Modification 4)

As shown in the processing sequence below, step a1 may not be performed, and steps B, a2, C, and D may be performed sequentially. Further, step C may also be performed when step B is performed, and step B may also be performed when step C is performed.

### {(First precursor + Second precursor) → Purge → Second inhibitor → Purge → (First precursor + Second precursor) → Purge → Reactant → Purge} × n

This modification may also obtain the same effects as in the above-described embodiments. In this modification, it is possible to increase the amount of adsorption of the first precursor and the second precursor on the wafer 200 per cycle, thus further improving a throughput.

### (Modification 5)

As shown in the processing sequence below, step a1 may not be performed, and steps B, a2, C, and D may be performed sequentially. Further, step C may also be performed when step B is performed.

### {(First precursor + Second precursor) → Purge → Second inhibitor → Purge → Second precursor → Purge → Reactant → Purge} × n

This modification may also obtain the same effects as in the above-described embodiments. In this modification, further, a relatively large amount of the first precursor may be adsorbed on the deeper side of the recess in step B, and a relatively large amount of the second precursor may be adsorbed on the opening side of the recess in step C. This allows a film to be formed at a uniform rate from the deeper side of the recess to the opening side thereof, and it is possible to improve the film thickness uniformity in the recess, particularly the step coverage when forming a film in the recess. In addition, in this modification, the amount of precursor used may be reduced compared to Modification 4 in which the step of performing step B and step C simultaneously is performed twice.

### (Modification 6)

As shown in the processing sequence below, step a1 may not be performed, and steps B, a2, C, and D may be performed sequentially. Further, step B may also be performed when step C is performed.

### {First precursor → Purge → Second inhibitor → Purge → (First precursor + Second precursor) → Purge → Reactant → Purge} × n

This modification may also obtain the same effects as in the above-described embodiments. In this modification, it is possible to shorten the cycle time, thus further improving a throughput. In addition, the amount of precursor used may be reduced compared to Modification 4 in which the step of performing step B and step C simultaneously is performed twice.

### (Modification 7)

As shown in the processing sequence below, steps a1, B, a2, C, and D may be performed sequentially. Further, step C may also be performed when step B is performed, and step B may also be performed when step C is performed.
{First inhibitor → Purge → (First precursor + Second precursor) → Purge → Second inhibitor → Purge → (First precursor + Second precursor) → Purge → Reactant → Purge} × n

This modification may also obtain the same effects as in the above-described embodiments. In this modification, it is possible to increase the amount of adsorption of the first precursor and the second precursor on the wafer 200 per cycle, thus further improving a throughput.

### (Modification 8)

As shown in the processing sequence below, steps a1, B, a2, C, and D may be performed sequentially, and step C may also be performed when step B is performed.
{First inhibitor → Purge → (First precursor + Second precursor) → Purge → Second inhibitor → Purge → Second precursor → Purge → Reactant → Purge} × n

This modification may also obtain the same effects as in the above-described embodiments. In this modification, further, a relatively large amount of first precursor may be adsorbed on the deeper side of the recess in step B, and a relatively large amount of second precursor may be adsorbed on the opening side of the recess in step C. This allows a film to be formed at a uniform rate from the deeper side of the recess to the open side thereof, and it is possible to improve the film thickness uniformity in the recess, particularly the step coverage when forming a film in the recess. In addition, in this modification, the amount of precursor used may be reduced compared to Modification 7 in which the step of performing step B and step C simultaneously is performed twice.

### (Modification 9)

As shown in the processing sequence below, steps a1, B, a2, C, and D may be performed sequentially, and step B may also be performed when step C is performed.
{First inhibitor → Purge → First precursor → Purge → Second inhibitor → Purge → (First precursor + Second precursor) → Purge → Reactant → Purge} × n

This modification may also obtain the same effects as in the above-described embodiments. In this modification, it is possible to increase the amount of adsorption of the first precursor and the second precursor on the wafer 200 per cycle, thus further improving a throughput. In addition, the amount of precursor used may be reduced compared to Modification 7 in which the step of simultaneously performing step B and step C is performed simultaneously.

### <Other Embodiments of the Present Disclosure>

The embodiments of the present disclosure are specifically described above. However, the present disclosure is not limited to the above-described embodiments, and various changes may be made without departing from the gist thereof.

For example, by making the amounts of first precursor and second precursor (tank charging amount) filled in the first reservoir 240a and the second reservoir 240b different, the state of adsorption of the first precursor and the second precursor on the wafer 200 in steps B and C may be regulated. For example, when the amount of first precursor filled in the first reservoir 240a is made larger than the amount of second precursor filled in the second reservoir 240b, the first precursor is supplied to the wafer 200 at a larger flow rate in a shorter time than the second precursor. Therefore, the first precursor supplied in step B is adsorbed on the deeper side of the recess more than the second precursor supplied in step C. In other words, in step B, a relatively large amount of first precursor may be adsorbed on the deeper side of the recess, and in step C, a relatively large amount of second precursor may be adsorbed on the opening side of the recess. This embodiment may also obtain the same effects as in the above-described embodiments.

On the other hand, when the amount of second precursor filled in the second reservoir 240b is made larger than the amount of first precursor filled in the first reservoir 240a, the second precursor is supplied to the wafer 200 at a larger flow rate in a shorter time than the first precursor. Therefore, the second precursor supplied in step C is adsorbed on the deeper side of the recess more than the first precursor supplied in step B. In other words, in step B, a relatively large amount of first precursor may be adsorbed on the opening side of the recess, and in step C, a relatively large amount of second precursor may be adsorbed on the deeper side of the recess. This embodiment may also obtain the same effects as in the above-described embodiments.

For example, by making the supply amounts of first inhibitor and second inhibitor different, the state of adsorption of the first precursor and the second precursor on the wafer 200 in steps B and C may be regulated. For example, when the supply amount of first inhibitor is made larger than the supply amount of second inhibitor, the first inhibitor supplied in step a1 is adsorbed on the opening side of the recess more than the second inhibitor supplied in step a2. Therefore, the first precursor supplied in step B is inhibited from being adsorbed on the opening side of the recess more than the second precursor supplied in step C, and therefore is adsorbed in a relatively large amount on the deeper side of the recess. In other words, in step B, a relatively large amount of first precursor may be adsorbed on the deeper side of the recess, and in step C, a relatively large amount of second precursor may be adsorbed on the opening side of the recess. This embodiment may also obtain the same effects as in the above-described embodiments.

On the other hand, when the supply amount of second inhibitor is made larger than the supply amount of first inhibitor, the second inhibitor supplied in step a2 is adsorbed on the opening side of the recess more than the first inhibitor supplied in step a1. Therefore, the second precursor supplied in step C is inhibited from being adsorbed on the opening side of the recess more than the first precursor supplied in step B, and therefore is adsorbed in a relatively large amount on the deeper side of the recess. In other words, in step C, a relatively large amount of second precursor may be adsorbed on the deeper side of the recess, and in step B, a relatively large amount of first precursor may be adsorbed on the opening side of the recess. This embodiment may also obtain the same effects as in the above-described embodiments.

In the above-described embodiments, a case where the first precursor and the second precursor are respectively flash-supplied in both steps B and C is described as an example. However, the present disclosure is not limited thereto. For example, the first precursor may be supplied (non-flash supply/conventional flow) into the process chamber 201 via the valve 243a, the first reservoir 240a, the valve 242a, the nozzle 249a, etc., without filling the first precursor in the first reservoir 240a in advance before performing step B. Alternatively, the second precursor may be supplied (non-flash supply/conventional flow) into the process chamber 201 via the valve 243b, the second reservoir 240b, the valve 242b, the nozzle 249b, etc., without filling the second precursor in the second reservoir 240b in advance before performing step C. This embodiment may also obtain at least some of the effects described in the above-described embodiments.

In the above-described embodiments, a case where the first inhibitor and the second inhibitor inhibit the first precursor and the second precursor from being adsorbed on the surface of the wafer 200 is described as an example. However, the present disclosure is not limited thereto. For example, the first inhibitor and the second inhibitor may be used as a modifying agent, a treatment agent, an accelerating agent, or a dopant agent. As an example, the first inhibitor may be used as an inhibitor in step a1, and the second inhibitor may be used as a treatment agent or a dopant agent in step a2. Herein, when the second inhibitor is used as the treatment agent, the second inhibitor may be, for example, an O- and H-containing gas, an O-containing gas, an O- and N-containing gas, an O- and C-containing gas, or the like. When the second inhibitor is used as the dopant agent, the second inhibitor may be, for example, a trichloroborane (BCl₃) gas, a phosphine (PH₃) gas, or the like. This embodiment may also obtain at least some of the effects described in the above-described embodiments.

In addition, in the above-described embodiments, the first precursor is described by taking, for example, a chlorosilane gas as an example. However, the present disclosure is not limited thereto. For example, the present disclosure may also be applied to a case where a first precursor containing a metal element such as aluminum (Al), titanium (Ti), hafnium (Hf), zirconium (Zr), tantalum (Ta), molybdenum (Mo), or tungsten (W) is used and a film containing a metal element such as an AlN film, a TiN film, a HfN film, a ZrN film, a TaN film, a molybdenum nitride film (MoN), a WN, an AlO film, a TiO film, a HfO film, a ZrO film, a TaO film, a MoO, a WO film, a TiON film, a TiAlCN film, a TiAlC film, or a TiCN film is formed on the wafer 200 according to the above-described processing sequence. This embodiment may also obtain the same effects as in the above-described embodiments.

In addition, in the above-described embodiments, the reactant is described by taking, for example, a N- and H-containing gas as an example. However, the present disclosure is not limited thereto. For example, a carbon (C)-containing gas such as a C₂H₄ gas, a C₂H₂ gas, or a C₃H₆ gas, a boron (B)-containing gas such as a B₂H₆ gas or a BCl₃ gas, an oxygen (O)-containing gas such as an oxygen (O₂) gas, an ozone (O₃) gas, a plasma-excited O₂ gas (O₂*), an O₂ gas + hydrogen (H₂) gas, water vapor (H₂O gas), a H₂O₂ gas, a N₂O gas, a NO gas, a NO₂ gas, a CO gas, or a CO₂ gas, etc., may be used. In the present disclosure, the reference to two gases such as "O₂ gas + H₂ gas" means a mixed gas of H₂ gas and O₂ gas. When supplying the mixed gas, the two gases may be mixed (pre-mixed) in a supply pipe and then supplied into the process chamber 201, or the two gases may be supplied separately from different supply pipes into the process chamber 201 and then mixed (post-mixed) in the process chamber 201. One or more of these gases may be used as the reactant. This embodiment may also obtain the same effects as in the above-described embodiments.

In addition, in the above-described embodiments, a case where a SiN film is formed on the wafer 200 in the substrate processing is exemplified. However, the present disclosure is not limited thereto. In addition to the SiN film, the present disclosure may also be applied to a case where a film containing Si, such as a SiCN film, a SiON film, a SiOC film, a SiOCN film, a SiBCN film, a SiBN film, or a SiO film, is formed. This embodiment may also obtain the same effects as in the above-described embodiments.

In addition, in the above-described embodiments, a case where the control part is a physical controller (the controller 121) is described as an example. However, the present disclosure is not limited thereto. The control part may be a software program that exists in a memory of the controller. This embodiment may also obtain the same effects as in the above-described embodiments.

In addition, in the above-described embodiments, a case where the gas supply system is configured by the first precursor supply system, the second precursor supply system, the reactant supply system, the first supply system, the second supply system, the inert gas supply system, and the controller 121 which is a control part to be described later is described as an example. However, the present disclosure is not limited thereto. For example, the gas supply system may be configured by the first precursor supply system, the second precursor supply system, the reactant supply system, the first supply system, the second supply system, the inert gas supply system, and a software program. Also, the control part may be configured by a software program. In addition, the gas supply system is configured to be controllable to perform the processing of the present disclosure.

Recipes used in each processing may be prepared individually according to processing contents and may be stored in the memory 121c via an electrical communication line or the external memory 123. Moreover, at the beginning of each processing, the CPU 121a may properly select an appropriate recipe from the recipes recorded and stored in the memory 121c according to the processing contents. Thus, it is possible for a single substrate processing apparatus to form films of various types, composition ratios, qualities, and thicknesses with enhanced reproducibility. Further, it is possible to reduce an operator's burden and to quickly start each processing while avoiding an operation error.

The recipes mentioned above are not limited to newly-prepared ones but may be prepared, for example, by modifying existing recipes that are already installed in the substrate processing apparatus. When modifying the recipes, the modified recipes may be installed in the substrate processing apparatus via an electrical communication line or a recording medium recording the recipes. In addition, the existing recipes already installed in the existing substrate processing apparatus may be directly modified by operating the input/output device 122 of the substrate processing apparatus.

An example in which a film is formed using a batch-type substrate processing apparatus capable of processing a plurality of substrates at a time is described in the above-described embodiments. The present disclosure is not limited to the above-described embodiments, but may also be suitably applied, for example, to a case where a film is formed using a single-wafer type substrate processing apparatus capable of processing a single substrate or several substrates at a time. In addition, an example in which a film is formed using a substrate processing apparatus provided with a hot-wall type process furnace is described in the above-described embodiments. The present disclosure is not limited to the above-described embodiments, but may also be suitably applied to a case where a film is formed using a substrate processing apparatus provided with a cold-wall type process furnace. In addition, an example in which a gas is activated by heat is described in the above-described embodiments. However, the present disclosure is not limited thereto. For example, the present disclosure may also be suitably applied to a case where a gas is activated by plasma generated inside or outside the process chamber 201, or a case where a gas is activated by irradiating the gas with electromagnetic waves by a lamp or the like.

Even in the case of using these substrate processing apparatuses, each processing may be performed according to the same processing procedures and processing conditions as those in the above-described embodiments and modifications, and the same effects as those of the above-described embodiments and modifications may be obtained.

The above-described embodiments and modifications may be used in proper combination. The processing procedures and processing conditions used in this case may be the same as, for example, the processing procedures and processing conditions in the above-described embodiments and modifications.

According to the present disclosure in some embodiments, it is possible to improve step coverage of a film formed on a substrate.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate (200), comprising:
forming a film on the substrate (200) by performing a cycle a predetermined number of times, the cycle including:
(a) supplying an inhibitor to the substrate (200);
(b) supplying a first precursor from a first reservoir (240a) to the substrate (200);
(c) supplying a second precursor from a second reservoir (240b) to the substrate (200); and
(d) supplying a reactant to the substrate (200).

2. The method of Claim 1, wherein (a) includes at least one selected from the group of (a-1) supplying a first inhibitor to the substrate (200) before (b) and (a-2) supplying a second inhibitor to the substrate (200) before (c).

3. The method of Claim 1 or 2, wherein (c) is also performed when (b) is performed, and (b) is performed when (c) is performed.

4. The method of Claim 1 or 2, wherein (c) is also performed when (b) is performed.

5. The method of Claim 1 or 2, wherein (b) is also performed when (c) is performed.

6. The method of any one of Claims 1 to 5, wherein in (b), the first precursor that is stored in the first reservoir (240a) is supplied, and
wherein in (c), the second precursor is supplied by passing through the second reservoir (240b).

7. The method of any one of Claims 1 to 5, wherein in (b), the first precursor is supplied by passing through the first reservoir (240a), and
wherein in (c), the second precursor that is stored in the second reservoir (240b) is supplied.

8. The method of any one of Claims 1 to 5, wherein in (b), the first precursor that is stored in the first reservoir (240a) is supplied, and
wherein in (c), the second precursor that is stored in the second reservoir (240b) is supplied.

9. The method of any one of Claims 1 to 8, wherein the first precursor and the second precursor are a same material.

10. The method of any one of Claims 1 to 8, wherein the first precursor and the second precursor are different materials.

11. A method of manufacturing a semiconductor device, comprising the method of any one of Claims 1 to 10.

12. A program that causes, by a computer, a substrate processing apparatus to perform a process comprising:
forming a film on a substrate (200) by performing a cycle a predetermined number of times, the cycle including:
(a) supplying an inhibitor to the substrate (200);
(b) supplying a first precursor from a first reservoir (240a) to the substrate (200);
(c) supplying a second precursor from a second reservoir (240b) to the substrate (200); and
(d) supplying a reactant to the substrate (200).

13. A substrate processing apparatus, comprising:
a first supply system configured to supply an inhibitor to a substrate (200);
a first precursor supply system that is installed with a first reservoir (240a) and is configured to supply a first precursor to the substrate (200);
a second precursor supply system that is installed with a second reservoir (240b) and is configured to supply a second precursor to the substrate (200);
a reactant supply system configured to supply a reactant to the substrate (200); and
a controller (121) configured to be capable of allowing the first supply system, the first precursor supply system, the second precursor supply system, and the reactant supply system to perform a process including:
forming a film on the substrate by performing a cycle a predetermined number of times, the cycle including:
(a) supplying the inhibitor to the substrate (200);
(b) supplying the first precursor to the substrate (200);
(c) supplying the second precursor to the substrate (200); and
(d) supplying the reactant to the substrate (200).
